# EUROPÄISCHE PATENTSCHRIFT

(11) **EP 1 191 595 B1**
(45) Veröffentlichungstag und Bekanntmachung des Hinweises auf die Patenterteilung: **19.08.2009**
(21) Anmeldenummer: 01120136.5
(22) Anmeldetag: 21.08.2001
(51) Int. Cl.: H01L 27/108, H01L 27/06

(54) **Integrierter Speicher mit Speicherzellen und Pufferkapazitäten**
Integrated memory device with memory cells and buffer capacitors
Mémoire integrée avec cellules de mémoire et condensateurs de tampon

(30) Priorität: 15.09.2000 DE 10045692
(43) Veröffentlichungstag der Anmeldung: 27.03.2002
(73) Patentinhaber: Infineon Technologies AG, 81669 München (DE)
(72) Erfinder: Feurle, Robert, 85579 Neubiberg (DE); Savignac, Dominique, Dr., 85737 Ismaning (DE)
(74) Vertreter: Epping - Hermann - Fischer

(56) Entgegenhaltungen:
- JP-A- 1 080 066
- JP-A- 11 214 649
- JP-A- 2000 188 379
- US-A- 5 759 907
- US-A- 6 034 391

## Beschreibung

Die vorliegende Erfindung betrifft einen integrierten Speicher mit Speicherzellen und Pufferkapazitäten.

Integrierte Speicher wie beispielsweise sogenannte DRAM-Speicher weisen üblicherweise Speicherzellen auf, die jeweils einen Auswahltransistor und eine Speicherkapazität enthalten. Die Speicherkapazitäten sind dabei über den jeweiligen Auswahltransistor jeweils mit einer von mehreren Spaltenleitungen eines matrixförmigen Speicherzellenfeldes verbunden. Die Steueranschlüsse der jeweiligen Auswahltransistoren sind jeweils mit einer von mehreren Zeilenleitungen verbunden, über die die Speicherzellen ausgewählt werden können.

Derartige Speicher weisen oftmals zusätzlich sogenannte Pufferkapazitäten auf zur Stabilisierung einer Spannungsversorgung auf dem Speicherchip. Sie dienen insbesondere zur Filterung von Spannungsspitzen und gewährleisten damit eine gewisse Spannungsfestigkeit des Speichers. Im Interesse einer weitgehend homogenen Flächenbelegung auf dem Speicherchip sind Pufferkapazitäten häufig ähnlich aufgebaut und angeordnet wie die Speicherzellen beziehungsweise deren Speicherkapazitäten. Das heißt, in diesem Fall weisen auch die Pufferkapazitäten einen jeweils zugeordneten Auswahltransistor auf. Sie sind dabei üblicherweise in einem Bereich der Peripherie des Speicherchips angeordnet, wobei dieser Bereich ebenfalls aus Gründen einer homogenen Flächenbelegung eine zu dem Speicherzellenfeld ähnliche Struktur aufweist. Eine homogene Flächenbelegung auf dem Speicherchip bringt insbesondere Vorteile für die Herstellung des Chips, beispielsweise verbesserte Planarisierungseigenschaften.

Um die Pufferkapazitäten dauerhaft zu aktivieren, ist der entsprechende Auswahltransistor dauerhaft leitend zu schalten. Da die Auswahltransistoren bei dauerhafter Belastung im allgemeinen schneller altern und dadurch schneller fehlerhaft werden können als die Pufferkapazitäten, kann somit deren Funktionsfähigkeit dadurch relativ schnell beeinträchtigt werden. Bei den Auswahltransistoren können außerdem Kurzschlüsse zwischen ihren jeweiligen Steueranschlüssen und ihren gesteuerten Strecken auftreten. Diese können beispielsweise durch schwankende beziehungsweise fehlerhafte Fertigungsprozesse entstehen. Weist ein Auswahltransistor einen Kurzschluß auf, so ist dadurch auch die Funktionsfähigkeit der zugehörigen Pufferkapazität beeinträchtigt. Da bei derartigen Speicherchips im allgemeinen für die Pufferkapazitäten keine entsprechende Redundanz vorgesehen ist, ist dadurch die Spannungsfestigkeit des Speicherchips insgesamt beeinträchtigt.

Die Druckschrift US 6,034,391 betrifft ein Halbleiterbauelement, bei dem zwischen verschiedenen Halbleiterschichten ein isolierender Film angebracht ist, wodurch eine kapazitive Struktur mit einer hohen Effizienz in Bezug auf die benötigte Fläche ausgebildet wird.

Die Aufgabe der vorliegenden Erfindung ist es, einen integrierten Speicher anzugeben, der Speicherzellen und Pufferkapazitäten in einer weitgehend homogenen Flächenbelegung aufweist, bei dem mittels der Pufferkapazitäten eine vergleichsweise hohe Spannungsfestigkeit dauerhaft herstellbar ist.

Die Aufgabe wird gelöst durch einen integrierten Speicher mit einem Speicherzellenfeld, das mehrere Spaltenleitungen und Zeilenleitungen aufweist, in dem Speicherzellen angeordnet sind, die jeweils einen Auswahltransistor und eine Speicherkapazität umfassen, bei dem je Speicherzelle die Speicherkapazität über den Auswahltransistor mit einer von mehreren Spaltenleitungen verbunden ist, bei dem je Speicherzelle ein Steueranschluß des Auswahltransistors mit einer von mehreren Zeilenleitungen verbunden ist, mit einem Gebiet, das weitere Spaltenleitungen und Zeilenleitungen aufweist, in dem Pufferkapazitäten vorgesehen sind, die jeweils mit einem Kontakt zu einer der weiteren Spaltenleitungen verbunden sind, und bei dem die Pufferkapazitäten derart angeordnet sind, daß die Verbindung zwischen der jeweiligen Pufferkapazität und dem Kontakt parallel zu einer der weiteren Zeilenleitungen angeordnet ist.

Die Pufferkapazitäten sind beispielsweise in einem Bereich der Peripherie des Speicherchips angeordnet. Dieser Bereich ist im Interesse einer homogenen Flächenbelegung ähnlich aufgebaut wie ein Speicherzellenfeld, in dem sich die Speicherzellen befinden. Das heißt, dieser Bereich weist ebenfalls Spaltenleitungen und Zeilenleitungen auf, wobei die Pufferkapazitäten jeweils mit einem Kontakt zu einer dieser Spaltenleitungen verbunden sind. Die Spaltenleitungen sind beispielsweise mit einem Anschluß für ein erstes Potential einer Spannungsversorgung verbunden, die jeweiligen Pufferkapazitäten mit einem Anschluß für ein zweites Potential der Spannungsversorgung. Das bedeutet, die Pufferkapazitäten dienen zum Ausgleich von Spannungsspitzen zwischen dem ersten Potential und dem zweiten Potential der Spannungsversorgung.

Da sowohl das Speicherzellenfeld, in dem die Speicherzellen angeordnet sind, als auch der Bereich, in dem die Pufferkapazitäten angeordnet sind, Spaltenleitungen und Zeilenleitungen aufweisen, ist eine weitgehend homogene Flächenbelegung gewährleistet. Die Zeilenleitungen und Spaltenleitungen des Speicherzellenfeldes dienen zur Auswahl beziehungsweise zum Auslesen oder Beschreiben der Speicherzellen, die Spaltenleitungen und Zeilenleitungen in dem Bereich, in dem die Pufferkapazitäten angeordnet sind, dienen der Herstellung einer erforderlichen Spannungsfestigkeit des Speicherchips.

Indem die Verbindung zwischen der jeweiligen Pufferkapazität und dem Kontakt zu der jeweiligen Spaltenleitung parallel zu einer der weiteren Zeilenleitungen herzustellen ist, kann bei der Herstellung des Speicherchips ein Diffusions-Serienwiderstand zwischen der betreffenden Pufferkapazität und dem Kontakt entstehen. Das heißt, die jeweilige Pufferkapazität und der Kontakt sind nicht über einen Auswahltransistor miteinander verbunden. Dadurch ergibt sich insbesondere der Vorteil, daß durch den fehlenden Auswahltransistor auch dessen Fehlermechanismen keinen Einfluß auf die Funktionsfähigkeit der Pufferkapazitäten ausüben können. Dadurch ist eine vergleichsweise hohe Spannungsfestigkeit des Speicherchips durch die Pufferkapazitäten sichergestellt.

Ein weiterer Vorteil der Erfindung liegt darin, daß die jeweiligen Zeilenleitungen nicht für eine Auswahl der entsprechenden Pufferkapazitäten in einem (dauerhaft) aktiven Zustand betrieben werden müssen. Da die betreffenden Zeilenleitungen bezüglich der Pufferkapazitäten keine Auswahlfunktion übernehmen, können diese mit einem gleichen Potential verbunden werden wie die mit den Pufferkapazitäten verbundenen Spaltenleitungen. Dadurch liegen diese Zeilenleitungen und Spaltenleitungen auf einem gleichen Potential, wodurch im Falle eines Kurzschlusses zwischen den betreffenden Leitungen kein Leckstrom auftritt.

In einer vorteilhaften Ausführungsform der Erfindung weisen die Pufferkapazitäten einen gleichen geometrischen Aufbau wie die Speicherkapazitäten auf. Neben einer weitergehenden Homogenisierung der Flächenbelegung wird dadurch auch der Herstellungsprozeß vereinfacht, da nur ein Kapazitätstyp beziehungsweise Kapazitätsaufbau, beispielsweise im Form einer Trench-Kapazität, vorgesehen ist.

Weitere vorteilhafte Aus- und Weiterbildungen sind in Unteransprüchen gekennzeichnet.

Die Erfindung wird im folgenden anhand der in der Zeichnung dargestellten Figuren, die Ausführungsbeispiele der Erfindung darstellen, näher erläutert. Es zeigen:
- Figur 1: einen schematischen Aufbau eines integrierten Speichers mit Speicherzellen und Pufferkapazitäten,
- Figur 2: eine Verschaltung von zwei Pufferkapazitäten,
- Figur 3: eine Draufsicht eines integrierten Speichers mit Pufferkapazitäten,
- Figur 4: einen Querschnitt von zwei Pufferkapazitäten,
- Figur 5: einen Querschnitt von zwei Speicherzellen.

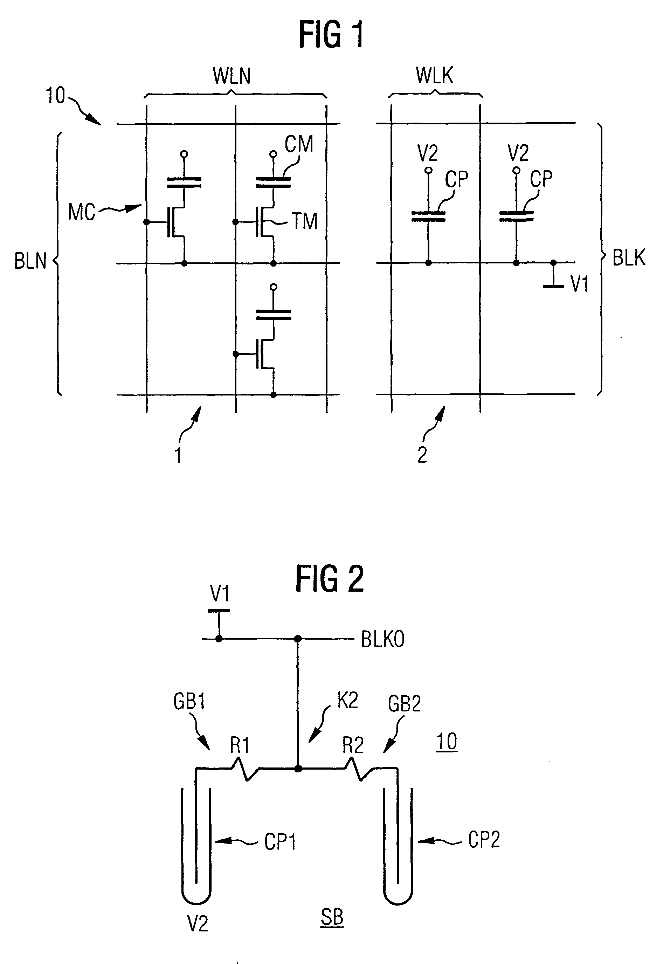

Figur 1 zeigt einen schematischen Aufbau eines integrierten Speichers 10, der Speicherzellen MC in einem Speicherzellenfeld 1 aufweist. Die Speicherzellen MC enthalten jeweils einen Auswahltransistor TM und eine Speicherkapazität CM. Je Speicherzelle MC ist die Speicherkapazität CM über den Auswahltransistor TM mit einer von mehreren Spaltenleitungen BLN verbunden. Ein Steueranschluß des jeweiligen Auswahltransistors TM ist mit einer von mehreren Zeilenleitungen WLN verbunden. Über die Zeilenleitungen WLN werden die Speicherzellen MC über den jeweiligen Auswahltransistor TM ausgewählt. Dazu wird die entsprechende Zeilenleitung WLN in einen aktiven Zustand versetzt, so daß der entsprechende Auswahltransistor TM leitend geschaltet ist. Die Spaltenleitungen BLN dienen zum Auslesen beziehungsweise zum Schreiben von Datensignalen, die in den Speicherkapazitäten CM gespeichert sind.

Der Speicher 10 weist außerdem Zeilenleitungen WLK und Spaltenleitungen BLK auf, die in einem Bereich 2 des Speicherchips angeordnet sind. Der Bereich 2 befindet sich günstigerweise in der Peripherie des Speichers 10. Der Bereich 2 enthält Pufferkapazitäten CP, die jeweils mit einer der Spaltenleitungen BLK verbunden sind. Die Spaltenleitungen BLK sind dabei jeweils mit einem ersten Potential V1 einer Versorgungsspannung verbunden, die jeweiligen Pufferkapazitäten CP mit ihrem jeweiligen anderen Anschluß mit einem zweiten Potential V2 der Spannungsversorgung. Die Pufferkapazitäten CP dienen insbesondere zur Filterung von Spannungsspitzen zwischen den Potentialen V1 und V2. Dadurch kann die Spannungsfestigkeit des Speichers 10 bezüglich der Potentiale V1 und V2 erhöht werden.

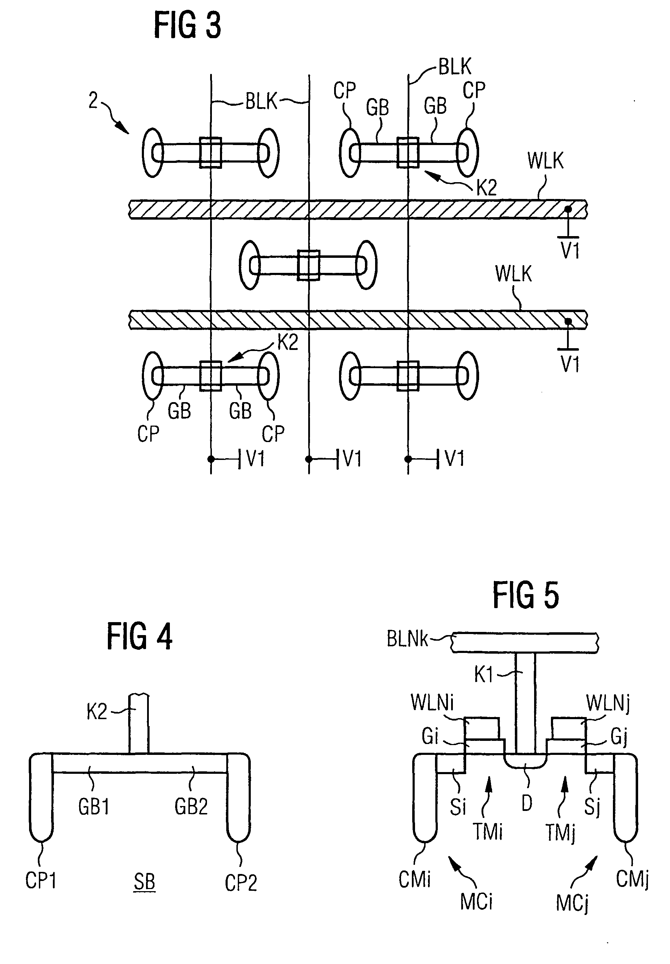

Figur 3 zeigt eine Draufsicht einer Ausführungsform eines erfindungsgemäßen Speichers mit Pufferkapazitäten CP. Das gezeigte Layout des Speichers 10 in dem Bereich 2 ist dabei grob schematisch dargestellt. Die Pufferkapazitäten CP sind jeweils über Bereiche GB mit Kontakten K2 verbunden. Die Kontakte K2 stellen dabei eine elektrische Verbindung zu einer der Spaltenleitungen BLK her. Die Kontakte K2 werden auch als sogenannte CB-Kontakte bezeichnet. Die Zeilenleitungen WLK sind nicht elektrisch mit den Gebieten GB verbunden. Sie liegen an dem Potential V1 an, ebenso die Spaltenleitungen BLK. Die Pufferkapazitäten CP sind derart angeordnet, daß die jeweilige Verbindung beziehungsweise das jeweilige Gebiet GB zwischen der jeweiligen Pufferkapazität CP und dem Kontakt K2 parallel zu der jeweiligen Zeilenleitung WLK angeordnet ist. Da die Kontakte K2 und die Pufferkapazitäten CP nicht über einen Auswahltransistor miteinander verbunden sind, ist insbesondere eine dauerhafte Funktionsfähigkeit der Pufferkapazitäten CP gewährleistet.

Figur 4 zeigt einen Querschnitt von zwei Pufferkapazitäten CP1 und CP2, die in einem Bereich 2 gemäß Figur 3 enthalten sind. Die Pufferkapazitäten CP1 und CP2 sind als Trench-Kapazitäten ausgeführt. Das heißt, sie sind in einem Substrat SB des Speichers durch einen sogenannten Trench gebildet. Die Pufferkapazitäten CP1 und CP2 sind über die jeweiligen Gebiete GB1 beziehungsweise GB2 mit dem Kontakt K2 verbunden. Die Gebiete GB1 und GB2 stellen dotierte Gebiete in dem Substrat SB dar. Sie bilden einen Diffusions-Serienwiderstand zwischen den Pufferkapazitäten CP1 beziehungsweise CP2 und dem Kontakt K2.

Eine Verschaltung der Pufferkapazitäten CP1 und CP2 gemäß Figur 4 ist schematisch in Figur 2 gezeigt. Die von den Gebieten GB1 und GB2 gebildeten Diffusions-Serienwiderstände sind durch die Widerstände R1 beziehungsweise R2 modelliert. Der Kontakt K2 ist mit einer beispielhaften Spaltenleitung BLK0 verbunden, die ihrerseits an dem Potential V1 anliegt. Das Substrat SB des Speichers 10 ist mit dem Potential V2 verbunden. Das heißt, die jeweilige Platte beziehungsweise Node der Pufferkapazitäten CP1 und CP2 liegt an dem Potential V2 an. Die Potentiale V1 und V2 werden über die Pufferkapazitäten CP1 und CP2 gegeneinander gepuffert.

Da die Zeilenleitungen WLK und die Spaltenleitungen BLK beziehungsweise die Kontakte K2 mit dem gleichen Potential V1 verbunden sind, ergibt sich der Vorteil, daß bei einem Kurzschluß zwischen den Leitungen kein Leckstrom zwischen diesen Leitungen auftreten kann.

Figur 5 zeigt einen Querschnitt zweier Speicherzellen MCi und MCj, die in einem Speicherzellenfeld 1 nach der Struktur gemäß Figur 1 enthalten sind. Deren Speicherkapazitäten CMi und CMj sind über jeweilige Auswahltransistoren TMi beziehungsweise TMj mit dem Kontakt K1 verbunden. Der Kontakt K1 ist dabei mit einer Spaltenleitung BLNk verbunden. Die Steueranschlüsse Gi und Gj der Transistoren TMi beziehungsweise TMj sind mit jeweiligen Zeilenleitungen WLNi beziehungsweise WLNj verbunden. Über die Zeilenleitungen WLNi und WLNj werden die Transistoren TMi beziehungsweise TMj leitend geschaltet. Dadurch werden die Speicherzellen MCi und MCj ausgewählt. Die Speicherkapazitäten CMi und CMj weisen einen gleichen geometrischen Aufbau wie die Pufferkapazitäten CP1 und CP2 aus Figur 4 auf. Die Transistoren TMi und TMj weisen die Sourcegebiete Si beziehungsweise Sj und das gemeinsame Draingebiet D auf.

In der Darstellung gemäß Figur 5 verlaufen die Zeilenleitungen WLNi und WLNj orthogonal zu den Transistoren TMi und TMj beziehungsweise orthogonal zu den Verbindungen zwischen den Speicherkapazitäten CMi und CMj und dem Kontakt K1. Ein Kurzschluß zwischen den Zeilenleitungen WLNi und/oder WLNj und dem Kontakt K1 beziehungsweise der Spaltenleitung BLNk kann die Funktionsfähigkeit der Transistoren TMi und TMj beeinträchtigen.

Da bei dem erfindungsgemäßen Speicher, wie in Figur 3 in Verbindung mit Figur 4 gezeigt, die Verbindungen zwischen den jeweiligen Pufferkapazitäten CP und den Kontakten K2 parallel zu den jeweiligen Zeilenleitungen WLK angeordnet sind, können durchgehende dotierte Gebiete GB ohne jeweilige Auswahltransistoren entstehen. Weist der integrierte Speicher Speicherzellen gemäß dem Aufbau nach Figur 5 auf, so sind die dotierten Gebiete GB1 und GB2 gemäß Figur 4 vorteilhaft entsprechend den Source- und Draingebieten der Transistoren TMi und TMj ausgebildet. Diese können daher in einem gemeinsamen Dotierungsprozeß hergestellt werden.

## Patentansprüche

1. Integrierter Speicher
- mit einem Speicherzellenfeld (1), das mehrere Spaltenleitungen (BLN) und Zeilenleitungen (WLN) aufweist, in dem Speicherzellen (MC) angeordnet sind, die jeweils einen Auswahltransistor (TM) und eine Speicherkapazität (CM) umfassen,
- bei dem je Speicherzelle (MC) die Speicherkapazität (CM) über den Auswahltransistor (TM) mit einer von mehreren Spaltenleitungen (BLN) verbunden ist,
- bei dem je Speicherzelle (MC) ein Steueranschluß des Auswahltransistors (TM) mit einer von mehreren Zeilenleitungen (WLN) verbunden ist,
- mit einem Gebiet (2), das weitere Spaltenleitungen (BLK) und Zeilenleitungen (WLK) aufweist, in dem Pufferkapazitäten (CP) vorgesehen sind, die jeweils mit einem Kontakt (K2) zu einer der weiteren Spaltenleitungen (BLK) verbunden sind,
- bei dem die Pufferkapazitäten (CP) derart angeordnet sind, daß die Verbindung (GB) zwischen der jeweiligen Pufferkapazität (CP) und dem Kontakt (K2) parallel zu einer der weiteren Zeilenleitungen (WLK) angeordnet ist.

2. Integrierter Speicher nach Anspruch 1,
**dadurch gekennzeichnet, daß**
die Pufferkapazitäten (CP1, CP2) jeweils über ein dotiertes Gebiet (GB1, GB2) mit dem Kontakt (K2) verbunden sind.

3. Integrierter Speicher nach Anspruch 2,
**dadurch gekennzeichnet, daß**
das dotierte Gebiet (GB1, GB2) wie ein entsprechendes dotiertes Gebiet (Si, Sj, D) eines der Auswahltransistoren (TMi, TMj) ausgebildet ist.

4. Integrierter Speicher nach einem der Ansprüche 1 bis 3,
**dadurch gekennzeichnet, daß**
- eine Anzahl der weiteren Zeilenleitungen (WLK) und der jeweilige Kontakt (K2) mit einem Anschluß für ein erstes Potential (V1) verbunden sind,
- die jeweiligen Pufferkapazitäten (CP) mit einem Anschluß für ein zweites Potential (V2) verbunden sind.

5. Integrierter Speicher nach einem der Ansprüche 1 bis 4,
**dadurch gekennzeichnet, daß**
die Pufferkapazitäten (CP) einen gleichen geometrischen Aufbau wie die Speicherkapazitäten (CM) aufweisen.

## Claims

1. Integrated memory
- with a memory cell field (1) comprising several coloumn lines (BLN) and row lines (WLN), wherein memory cells (MC) are arranged, each comprising a selection transistor (TM) and a memory capacity (CM),
- wherein per memory cell (MC) the memory capacity (CM) is connected with one of several coloumn lines (BLN) via the selection transistor (TM),
- wherein per memory cell (MC) a control terminal of the selection transistor (TM) is connected with one of several row lines (WLN),
- with a region (2) comprising further coloumn lines (BLK) and row lines (WLK), in which buffer capacities (CP) are provided which are each connected with a contact (K2) to one of the further coloumn lines (BLK),
- wherein the buffer capacities (CP) are arranged such that the connection (GB) between the respective buffer capacity (CP) and the contact (K2) is arranged parallel to one of the further row lines (WLK).

2. Integrated memory according to claim 1,
**characterized in that**
the buffer capacities (CP1, CP2) are each connected with the contact (K2) via a doped region (GB1, GB2).

3. Integrated memory according to claim 2,
**characterized in that**
the doped region (GB1, GB2) is formed like a respective doped region (Si, Sj, D) of one of the selection transistors (TMi, TMj).

4. Integrated memory according to one of the claims 1 to 3,
**characterized in that**
- a number of the further row lines (WLK) and the respective contact (K2) are connected with a terminal for a first potential (V1),
- the respective buffer capacities (CP) are connected with a terminal for a second potential (V2).

5. Integrated memory according to one of the claims 1 to 4,
**characterized in that**
the buffer capacities (CP) comprise the same geometrical layout as the memory capacities (CM).

## Revendications

1. Mémoire intégrée
- avec un champ de cellules de mémoire qui contient plusieurs conduites de colonnes (BLN) et conduites de lignes (WLN), dans lequel des cellules de mémoires sont disposées qui chacune comprennent un transistor de choix (TM) et une capacité de mémoire (CM),
- la capacité de mémoire (CM) étant liée par le transistor de choix à une de plusieurs conduites des colonnes (BLN) pour chaque cellule de mémoire (MC),
- une gâchette du transistor de choix (TM) étant liée à une de plusieurs conduites de lignes (WLN) pour chaque cellule de mémoire (MC),
- avec une zone (2) qui contient d'autres conduites de colonnes (BLK) et conduites de lignes (WLK), dans laquelle des capacités de butoir (CP) sont prévues, qui sont chacune liées à un contact (K2) à une des autres conduites de colonnes (BLK).
- les capacités de butoir (CP) étant disposées d'une manière que la connexion (GB) entre chaque capacité de butoir (CP) et le contact (K2) est disposée parallèlement à une des autres conduites de lignes (WLK).

2. Mémoire intégrée selon la revendication 1, **caractérisée en ce que** les capacités de butoir (CP1, CP2) sont chacune liées à travers d'une zone dotée (GB1, GB2) au contact (K2).

3. Mémoire intégrée selon la revendication 2, **caractérisée en ce que** la zone dotée (GB1, GB2) est formée comme une zone dotée correspondante (Si, Sj, D) d'un des transistors de choix (TMi, TMj).

4. Mémoire intégrée selon l'une des revendications 1 à 3,
**caractérisée en ce que**
- un nombre des autres conduites de lignes (WLK) et le contact respectif sont liés à une connexion pour un premier potentiel (V1),
- les capacités de butoir respectives (CP) sont liées à une connexion pour un deuxième potentiel (V2).

5. Mémoire intégrée selon une des revendications 1 à 4, **caractérisée en ce que** les capacités de butoir (CP) comportent la même structure géométrique que les capacités de mémoire (CM).
